(19) Europäisches Patentamt
European Patent Office
Office européen des brevets

(11) **EP 3 171 404 B1**

(12) **FASCICULE DE BREVET EUROPEEN**

(45) Date de publication et mention
de la délivrance du brevet:
**27.12.2017 Bulletin 2017/52**

(21) Numéro de dépôt: **16199386.0**

(22) Date de dépôt: **17.11.2016**

(51) Int Cl.:
**H01L 25/16** *(2006.01)*      *H01L 27/15 (2006.01)*

(54) **DISPOSITIF OPTOELECTRONIQUE A DIODES ELECTROLUMINESCENTES COMPORTANT AU MOINS UNE DIODE ZENER**

OPTOELEKTRONISCHE VORRICHTUNG MIT LEUCHTDIODEN, DIE MINDESTENS EINE ZENER-DIODE UMFASST

OPTOELECTRONIC DEVICE WITH LIGHT-EMITTING DIODES COMPRISING AT LEAST ONE ZENER DIODE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.11.2015 FR 1561195**

(43) Date de publication de la demande:
**24.05.2017 Bulletin 2017/21**

(73) Titulaire: **Commissariat à l'Énergie Atomique et aux Énergies Alternatives**
**75015 Paris (FR)**

(72) Inventeurs:
• **BONO, Hubert**
**38000 GRENOBLE (FR)**
• **ROBIN, Ivan-Christophe**
**38000 GRENOBLE (FR)**

(74) Mandataire: **GIE Innovation Competence Group**
**310, avenue Berthelot**
**69372 Lyon Cedex 08 (FR)**

(56) Documents cités:
WO-A2-2006/098545     CN-A- 104 091 799
JP-A- 2012 094 811     KR-B1- 100 635 346
US-A1- 2010 019 264     US-A1- 2014 246 686

**Description**

**DOMAINE TECHNIQUE**

Le domaine de l'invention est celui de la protection de type ESD (pour *Electrostatic Discharge,* en anglais) des dispositifs optoélectroniques, et en particulier des dispositifs optoélectroniques à diodes électroluminescentes.

**ÉTAT DE LA TECHNIQUE ANTÉRIEURE**

On connaît les dispositifs optoélectroniques à diodes électroluminescentes, celles-ci étant généralement formées d'un empilement de couches semiconductrices adapté à émettre un rayonnement lumineux, par exemple bleu ou ultraviolet, voire vert ou rouge. Les couches semiconductrices sont habituellement réalisées en un matériau comportant majoritairement un composé semiconducteur par exemple III-V, c'est-à-dire comprenant des éléments de la colonne III et de la colonne V du tableau périodique, tel qu'un composé III-N, par exemple le nitrure de gallium (GaN), le nitrure d'indium et de gallium (InGaN) ou le nitrure d'aluminium et de gallium (AlGaN).

Le fait de connecter en série une pluralité de diodes électroluminescentes permet d'obtenir une tension de fonctionnement plus élevée que la tension unitaire de fonctionnement de chaque des diodes, limitant ainsi la nécessité d'avoir recours à des éléments électroniques (capacités, convertisseurs...) assurant l'adaptation de la tension d'alimentation issue par exemple du secteur (par exemple 320V de tension crête pour une tension alternative de 230V) à la tension unitaire de fonctionnement des diodes (habituellement de l'ordre de 3V).

Il importe d'assurer la protection de chaque des diodes électroluminescentes connectées en série vis-à-vis de tensions présentant une intensité anormalement élevée, telle que les décharges électrostatiques, qui sont susceptibles de provoquer une dégradation structurelle irréversible des diodes électroluminescentes.

Une solution consiste généralement à connecter une diode Zener en parallèle à chacune des diodes électroluminescentes, voire une paire de diodes Zener connectées en tête-bêche. En effet, les diodes Zener présentent une tension inverse dite de claquage à partir de laquelle elles passent d'un état bloqué dans lequel le courant électrique ne circule sensiblement pas à un état passant présentant une résistance électrique très faible. Aussi, lorsqu'une tension anormalement élevée est subie par les diodes électroluminescentes, les diodes Zener passent de l'état bloqué à l'état passant de sorte que le courant électrique circule essentiellement au-travers de ces dernières, préservant ainsi les diodes électroluminescentes d'une potentielle dégradation structurelle irréversible. Habituellement, à des diodes électroluminescentes réalisées à base d'un composé III-V, tel que du GaN, dont la tension de seuil est de l'ordre de 3V, sont associées des diodes Zener réalisées à base de silicium dont la tension de claquage est de l'ordre de 5V.

Le document US 2011/0057569 A1 décrit un exemple de dispositif optoélectronique comportant une pluralité de diodes électroluminescentes connectées en série et réalisées à base de GaN, où chacune des diodes électroluminescentes est connectée en parallèle avec une diode Zener réalisée à base de silicium, les diodes Zener étant formées dans un même substrat en silicium.

Le document US 2010/019264 A1 décrit un exemple de dispositif optoélectronique comportant des diodes électroluminescentes monolithiques dont une est utilisée comme diode Zener.

Il existe cependant un besoin de disposer d'un dispositif optoélectronique, présentant une structure simplifiée, comportant une pluralité de diodes électroluminescentes connectées en série qui bénéficient chacune d'une protection vis-à-vis des décharges électrostatiques ou des tensions équivalentes. Il existe également un besoin d'un dispositif optoélectronique présentant une structure monolithique qui autorise une forte densité de diodes électroluminescentes.

**EXPOSÉ DE L'INVENTION**

L'invention a pour objectif de remédier au moins en partie aux inconvénients de l'art antérieur, et plus particulièrement de proposer un dispositif optoélectronique comportant des diodes électroluminescentes présentant chacune une tension directe dite de seuil et une tension inverse de claquage, réalisées en un matériau comportant majoritairement un même composé semiconducteur.

Selon l'invention, les diodes électroluminescentes sont agencées de sorte que :

- une pluralité de N diodes électroluminescentes, N>2, sont connectées en série et aptes à être polarisées en direct ;
- au moins une diode électroluminescente est connectée en parallèle à la pluralité des N diodes électroluminescentes, et apte à être polarisée en inverse formant ainsi une diode Zener ;
- le nombre N desdites diodes électroluminescentes connectées en série étant adapté de sorte que la somme des N tensions de seuil soit inférieure à la tension de claquage de la diode Zener.

Certains aspects préférés mais non limitatifs de cette source sont les suivants :

La diode Zener peut comporter un empilement de portions semiconductrices dont une première portion dopée selon un premier type de conductivité, une seconde portion dopée selon un second type de conductivité opposé au premier type, ainsi qu'une première portion intermédiaire dopée selon le premier type de conductivité, située entre lesdites première et seconde portions dopées, présentant un niveau de dopage adapté de sorte que la tension de claquage (Vc) soit supérieure à la somme des N tensions de seuil (Vs).

Les diodes électroluminescentes peuvent comporter un empilement de portions semiconductrices dont une première portion dopée selon le premier type de conductivité, une seconde portion dopée selon le second type de conductivité, ainsi qu'une première portion intermédiaire dopée selon le premier type de conductivité, située entre lesdites première et seconde portions dopées, lesdites portions semiconductrices des diodes électroluminescentes et de la diode Zener étant respectivement sensiblement coplanaires et réalisées en un matériau de même composition et de même niveau de dopage.

Les premières portions intermédiaires dopées des diodes électroluminescentes et de la diode Zener peuvent présenter une épaisseur inférieure ou égale à 5nm, et de préférence comprise entre 1nm et 5nm.

La diode Zener peut comporter une seconde portion intermédiaire dopée selon le second type de conductivité, située entre la première portion intermédiaire dopée et la seconde portion dopée, présentant un niveau de dopage adapté de sorte que la tension de claquage soit supérieure à la somme des N tensions de seuil.

Les diodes électroluminescentes peuvent comporter une seconde portion intermédiaire dopée selon le second type de conductivité, située entre la première portion intermédiaire dopée et la seconde portion dopée, lesdites secondes portions intermédiaires dopées des diodes électroluminescentes et de la diode Zener étant respectivement sensiblement coplanaires et réalisées en un matériau de même composition et de même niveau de dopage, et présentant une épaisseur inférieure ou égale à 50nm, et de préférence comprise entre 1nm et 50nm.

Ledit composé semiconducteur peut être choisi parmi un composé III-V, un composé II-VI, et un élément ou un composé IV.

Lesdites diodes électroluminescentes et la diode Zener peuvent présenter chacune un empilement de portions semiconductrices comprenant une première portion dopée selon un premier type de conductivité, une zone active, et une seconde portion dopée selon un second type de conductivité opposé au premier type, lesdits empilements formant chacun une structure mesa sensiblement coplanaire.

La première portion dopée des diodes électroluminescentes et celle de la diode Zener peuvent présenter un flanc latéral comportant une surface de décrochement formée par une seconde partie de la première portion dopée vis-à-vis d'une première partie de celle-ci.

Un élément de connexion électrique latéral peut s'étendre au niveau d'une diode électroluminescente ou de la diode Zener de manière à être au contact électrique avec la surface de décrochement de la première portion dopée correspondante, l'élément de connexion latéral étant en outre électriquement isolé des secondes portions dopées et des portions actives de la diode considérée et de la diode électroluminescente ou de la diode Zener adjacente, par des portions diélectriques recouvrant des flancs latéraux des structures mesa.

L'invention porte également sur un procédé de réalisation d'un dispositif optoélectronique selon l'une quelconque des caractéristiques précédentes, dans lequel :

i) on forme des diodes électroluminescentes réalisées en un matériau comportant majoritairement un même composé semiconducteur,
ii) on connecte en série une pluralité de N diodes électroluminescentes, N>2, celles-ci étant aptes à être polarisées en direct ;
iii) on connecte au moins une diode électroluminescente en parallèle à ladite pluralité de N diodes électroluminescentes, de manière à être polarisée en inverse formant ainsi une diode Zener, le nombre N desdites diodes électroluminescentes connectées en série étant adapté de sorte que la somme des N tensions de seuil soit inférieure à la tension de claquage de la diode Zener.

L'étape i) peut comporter les sous-étapes dans lesquelles :

a. on réalise un empilement de couches comprenant une première couche semiconductrice dopée et une seconde couche semiconductrice dopée entre lesquelles est interposée une couche active ;
b. on grave l'empilement de couches de manière à former une structure mesa destinée à former une pluralité de N diodes électroluminescentes et une structure mesa destinée à former au moins une diode Zener, chaque structure mesa étant formée d'un empilement d'une première portion dopée, d'une zone active et d'une seconde portion dopée, la première portion dopée desdites structures mesa comportant un flanc latéral présentant une surface de décrochement ;
c. on réalise des portions diélectriques recouvrant les flancs latéraux des structures mesa à l'exception des surfaces de décrochement ;

d. on dépose un matériau électriquement conducteur entre les structures mesa, le matériau conducteur étant en contact de la surface de décrochement de la première portion dopée et électriquement isolé par des portions diélectriques de la zone active et de la seconde portion dopée.

On peut réaliser en outre, lors de l'étape a), une première couche intermédiaire dopée selon le premier type de conductivité, située entre la couche active et la seconde couche dopée, et de préférence une seconde couche intermédiaire dopée selon le second type de conductivité, située entre la première couche intermédiaire et la seconde couche dopée.

On peut ajuster le niveau de dopage de la première couche intermédiaire et éventuellement de celui de la seconde couche intermédiaire dopée de sorte que la tension de claquage de la diode Zener soit inférieure à la somme des N tensions de seuil.

On peut réaliser des éléments de connexion électrique adaptés à polariser en direct la pluralité des N diodes électroluminescentes et en inverse la diode Zener à partir de portions électriquement conductrices de polarisation situées en regard des secondes portions dopées.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1 illustre un schéma électrique équivalent d'un dispositif optoélectronique comportant une pluralité de diodes électroluminescentes connectées en série, les diodes étant régulées en tension par deux diodes Zener connectées en tête-bêche ;

la figure 2 est une vue partielle schématique et en coupe d'un dispositif optoélectronique selon un mode de réalisation, dans lequel les diodes électroluminescentes et la diode Zener présentent chacune une structure mesa coplanaire ;

la figure 3 est une vue schématique détaillée de l'empilement de portions semiconductrices d'une diode électroluminescente et de la diode Zener d'un dispositif optoélectronique selon une variante du mode de réalisation illustré sur la figure 2, comportant des portions intermédiaires dopées situées entre la zone active et la seconde portion dopée ;

la figure 4 est une vue partielle schématique et en coupe d'un dispositif optoélectronique selon un autre mode de réalisation, dans lequel la liaison entre la puce optoélectronique et la puce de commande est assurée par des billes électriquement conductrices ;

les figures 5a à 5h illustrent les étapes d'un procédé de réalisation d'un dispositif optoélectronique selon un mode de réalisation.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les termes « sensiblement », « approximativement », « environ » s'entendent « à 10% près ».

L'invention porte sur la protection, dite ESD (pour *Electrostatic Discharge,* en anglais), de plusieurs diodes électroluminescentes connectées en série vis-à-vis de décharges électrostatiques ou de tensions anormalement élevées susceptibles d'endommager de manière irréversible la structure des diodes électroluminescentes.

La protection ESD est assurée par au moins une diode connectée en parallèle avec la pluralité de diodes électroluminescentes et agencée de manière à être polarisée en inverse vis-à-vis de la pluralité de diodes électroluminescentes. Cette diode est alors régulatrice de tension et est appelée par la suite diode Zener.

Chaque diode électroluminescente présente, lorsqu'elle est polarisée en direct, une tension dite de seuil Vs à partir de laquelle la diode émet un rayonnement lumineux. La même diode présente, alors polarisée en inverse, une tension dite de claquage Vc, également appelée tension Zener, à partir de laquelle la diode passe d'un état dit bloquant dans lequel le courant électrique ne circule sensiblement pas (moyennant un courant de fuite) à un état dit passant dans lequel la résistance électrique de la diode est très faible. La tension de claquage Vc peut être associée à un effet Zener ou à un effet d'avalanche. L'état passant de la diode Zener est effectif lorsque la valeur de tension inverse est comprise entre une valeur minimale sensiblement égale à la tension de claquage Vc et une valeur maximale au-delà de laquelle le courant électrique correspondant est susceptible d'entraîner une dégradation irréversible de la structure de la diode.

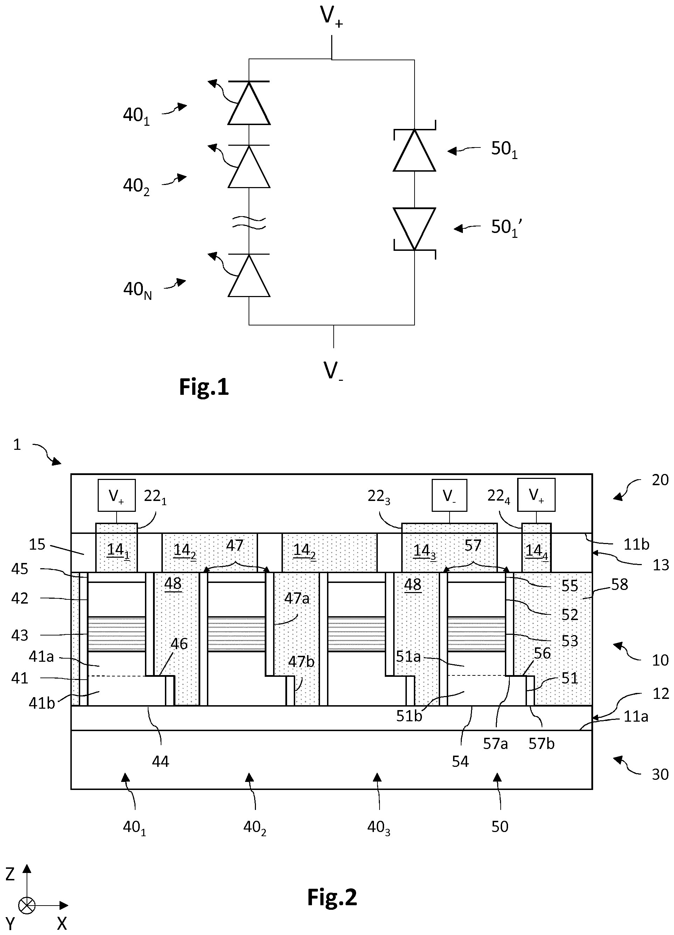

La figure 1 est un exemple de schéma électrique équivalent d'un dispositif optoélectronique selon un mode de réalisation, dans lequel une diode Zener assure la régulation électrique d'une pluralité de N diodes électroluminescentes, N≥2, connectées en série.

Le dispositif optoélectronique comporte des diodes électroluminescentes, présentant chacune une tension directe de seuil Vs et une tension inverse de claquage Vc, réalisées en un matériau comportant majoritairement le même composé semiconducteur. Par matériau comportant majoritairement le même composé semiconducteur, on entend un matériau dont au moins 50% de son volume est formé ou comporte ledit composé semiconducteur.

Le composé semiconducteur est choisi parmi les composés III-V, c'est-à-dire comprenant principalement au moins un élément de la colonne III et un élément de la colonne V du tableau périodique, les composés II-VI, et les éléments ou composés IV. Le composé III-V peut être un composé III-N, tel que par exemple le GaN, l'InGaN, l'AlGaN, l'AlN, l'InN, l'AlInGaN. Des éléments de la colonne V, tels que l'arsenic ou le phosphore, peuvent être présents dans un composé du type InP ou InGaAs. Le composé II-VI peut être, par exemple, le ZnO, le CdTe ou le CdHgTe. Le composé IVpeut être, par exemple, le SiC, le diamant (C), le SiGe, le GeSn voire le SiGeSn.

Ainsi, du fait que les diodes électroluminescentes sont réalisées en un matériau comportant majoritairement le même composé semiconducteur, elles présentent toutes une valeur sensiblement identique de tension de seuil Vs et une valeur sensiblement identique de tension de claquage Vc.

Il apparaît que les diodes électroluminescentes réalisées en un matériau comprenant majoritairement un tel composé semiconducteur présentent une tension inverse de claquage supérieure à au moins deux fois la tension directe de seuil. A titre d'exemple, la publication de Chang et al. intitulée Improved ESD Protection by Combining InGaN-GaN MQW LEDs With GaN Schottky Diodes, IEEE Electron Device Letters, Vol.24, No.3, 2003, 129-131, décrit une diode électroluminescente à base de GaN dont la tension inverse de claquage est de 170V environ alors que la tension directe de seuil est de l'ordre de 3V à 5V.

Il est alors possible d'utiliser l'une des diodes électroluminescentes, polarisée en inverse, formant ainsi une diode Zener qui assure la régulation électrique d'une pluralité des diodes électroluminescences connectées en série. Ainsi, les diodes électroluminescentes du dispositif optoélectronique sont agencées de manière à former, d'une part, une pluralité de N diodes électroluminescentes $40_1$, $40_2$,...$40_N$ connectées en série, N≥2, et d'autre part, au moins une diode électroluminescente connectée en parallèle à ladite pluralité de diodes électroluminescentes, et agencée de manière à être polarisée en inverse, formant ainsi la diode Zener.

De plus, le nombre N de diodes électroluminescentes connectées en série est alors adapté de sorte que la somme des N tensions directes de seuil est inférieure à la tension de claquage Vc de la diode Zener :

$$\sum_{1}^{N} Vs < Vc$$

De préférence, le nombre N de diodes électroluminescentes est également adapté de sorte que la tension de claquage soit inférieure à 2 fois, de préférence 1,5 fois et de préférence encore 1,25 fois la somme des N tensions directes de seuil. La protection ESD des diodes électroluminescentes connectées en série en est alors améliorée.

Ainsi, en fonctionnement, une tension de polarisation est appliquée à la pluralité de diodes électroluminescentes avec une valeur Vp d'une part inférieure (en valeur absolue) à la tension de claquage Vc de manière à ce que la diode Zener soit dans l'état bloqué, et d'autre part supérieure à la somme des N tensions de seuil de sorte que les diodes électroluminescentes émettent un rayonnement lumineux.

$$\sum_{1}^{N} Vs < Vp < Vc$$

Lorsqu'une décharge électrostatique apparaît, la tension présente alors une valeur supérieure à la somme des N tensions de seuil mais également supérieure à la tension de claquage. La diode Zener passe alors de l'état bloqué à l'état passant, ce qui permet d'éviter que le courant électrique ne traverse les diodes électroluminescentes et ne provoque une dégradation irréversible de leur structure.

Dans cet exemple, la diode Zener 50 est connectée en série et en tête bêche avec une seconde diode Zener 50' de manière à assurer une régulation électrique quel que soit le signe de la tension de décharge électrostatique. Par connexion en tête-bêche, on entend que les deux diodes Zener sont connectées en série au niveau de leur anode respective (comme illustré) ou au niveau de leur cathode respective.

A titre d'exemple, les diodes électroluminescentes et la diode Zener sont réalisées en un matériau comprenant majoritairement le composé GaN et présentent une même valeur de tension directe de seuil, égale à 3V environ, et une même valeur de tension inverse de claquage, égale à 170V environ. Le dispositif optoélectronique peut ainsi comporter, en parallèle avec la diode Zener, entre 29 et 57 diodes électroluminescentes environ connectées en série, et de préférence entre 37 et 57 diodes électroluminescentes environ, et de préférence encore entre 45 et 57 diodes électroluminescentes environ, par exemple 50 diodes électroluminescentes.

La figure 2 est une vue partielle en coupe schématique d'un dispositif optoélectronique selon un mode de réalisation, comportant ici trois diodes électroluminescentes (à titre purement illustratif) connectées en série et régulées en tension par une diode Zener en parallèle.

On définit ici et pour la suite de la description un repère orthonormé tridimensionnel (X,Y,Z), où le plan (X,Y) est sensiblement parallèle au plan des surfaces d'émission des diodes électroluminescentes, et où l'axe Z est orienté suivant une direction orthogonale aux surfaces d'émission.

Le dispositif optoélectronique 1 comporte ici :

- une première puce de circuit imprimé 10, dite puce optoélectronique, comportant une pluralité de diodes électroluminescentes 40 connectées en série, et au moins une diode Zener 50 ici disposée de manière adjacente à l'une des diodes électroluminescentes. La puce optoélectronique 10 comporte ici une matrice de diodes électroluminescentes 40 définissant une matrice de pixels lumineux.
- une seconde puce de circuit imprimé 20, dite puce de commande, disposée sur une face dite arrière 11b de la puce optoélectronique 10. La puce de commande 20 comporte des éléments de connexion permettant de polariser les diodes électroluminescentes 40 et la diode Zener 50.
- un capot 30, disposé sur une face dite avant 11a de la puce optoélectronique 10, opposée à la face arrière 11b.

La puce optoélectronique 10 comporte une pluralité de diodes électroluminescentes 40 connectées en série, et au moins une diode Zener 50 connectée en parallèle avec la pluralité de diodes 40. Chacune des diodes 40, 50 est formée d'un empilement de portions semiconductrices comprenant chacune majoritairement le même composé semiconducteur. Les diodes 40, 50 comportent ainsi une première portion dopée d'un premier type de conductivité et une seconde portion dopée d'un second type de conductivité entre lesquelles se situe une zone active. La zone active est la région d'une diode électroluminescente à partir de laquelle un rayonnement lumineux est majoritairement émis.

Les diodes électroluminescentes 40 et la diode Zener 50 forment des structures mesa sensiblement coplanaires les unes aux autres. Par structure mesa, on entend une structure formée d'un empilement de portions semiconductrices dont la zone active est en saillie au-dessus d'un substrat de croissance à la suite d'une étape de gravure. La structure des diodes électroluminescentes et de la diode Zener peut être identique ou similaire à la structure décrite dans la publication de Fan et al intitulée III-nitride micro-emitter arrays development and applications, J. Phys. D: Appl. Phys. 41 (2008) 094001. En variante, comme illustré sur la figure 2, elle peut être identique ou similaire à la structure décrite dans la demande de brevet FR1456085 déposée le 27/06/2014 dont le texte est considéré comme faisant partie intégrante de la présente description. Les structures mesa sont sensiblement coplanaires dans le sens où les portions semiconductrices des diodes électroluminescentes et celles de la diode Zener sont mutuellement coplanaires.

Chaque diode électroluminescente 40 comprend un empilement formé d'une première portion 41 dopée d'un premier type de conductivité, par exemple de type N, et d'une seconde portion 42 dopée d'un second type de conductivité opposé au premier type, par exemple de type P entre lesquelles est intercalée une zone active 43 dite émissive au niveau de laquelle est généré le rayonnement lumineux de la diode. Une face de la première portion 41 dopée N, opposée à la zone active 43, forme une surface d'émission 44 au travers de laquelle est émis le rayonnement lumineux.

La diode Zener 50 comprend un empilement formé d'une première portion 51 dopée d'un premier type de conductivité, par exemple de type N, et d'une seconde portion 52 dopée d'un second type de conductivité opposé au premier type, par exemple de type P, entre lesquelles est intercalée une zone active 53. Une face 54 de la première portion 51 dopée N, opposée à la zone active 53, est sensiblement coplanaire avec les surfaces d'émission 44.

Dans cet exemple, chaque portion semiconductrice 41, 42, 43 des diodes électroluminescentes 40 est respectivement coplanaire à celle 51, 52, 53 de la diode Zener 50, et présentent une épaisseur et une composition sensiblement identiques. Plus précisément, les premières portions 41 dopées N des diodes électroluminescentes 40 sont coplanaires à celle 51 de la diode Zener 50, et présentent une épaisseur et une composition sensiblement identiques. Par matériau de même composition, on entend un matériau comportant un composé semiconducteur dont les éléments présentent une proportion atomique sensiblement identique. Le niveau de dopage est de préférence également sensiblement identique. Il en est de même pour les secondes portions 42, 52 dopées P et pour les zones actives 43, 53. Ainsi, les épaisseurs des diodes électroluminescentes et des diodes Zener sont sensiblement identiques. Par ailleurs, la surface d'émission 44 et la surface 54 sont sensiblement coplanaires. Chaque diode électroluminescente 40 et diode Zener 50 comporte en outre une portion électriquement conductrice 45, 55 au contact d'une face de la seconde portion 42, 52 dopée opposée à la zone active 43, 53. L'épaisseur de la portion conductrice 45, 55 peut être comprise entre 3nm et 500nm. Les portions conductrices 45, 55 sont de préférence sensiblement coplanaires.

Chaque diode électroluminescente 40 et diode Zener 50 présente ici une structuration de la première portion 41, 51 dopée N formant un décrochement au niveau d'un flanc latéral de l'empilement se traduisant par un élargissement local des dimensions latérales dans le plan (X,Y). Plus précisément, chaque première portion 41, 51 dopée N comporte une première partie 41a, 51a, située entre la zone active 43, 53 et une seconde partie 41b, 51b, dont les dimensions latérales sont sensiblement identiques à celles de la zone active 43, 53. Elle comporte également une seconde partie 41b, 51b, dont la face opposée à la première partie 41a, 51a forme les surfaces 44, 54, dont les dimensions latérales sont supérieures à celles de la première partie 41a, 51a au niveau d'un flanc latéral de l'empilement. Ainsi, la première portion 41, 51 dopée N des diodes 40, 50 comporte une surface de décrochement 46, 56 qui s'étend de manière sensiblement orthogonale à l'axe Z et qui relie les flancs latéraux des premières parties 41a, 51a et secondes parties 41b, 51b. Par ailleurs, la zone active 43, 53 et la seconde portion 42, 52 dopée P des diodes 40, 50 comportent des flancs latéraux qui s'étendent continûment suivant l'axe Z. Les dimensions latérales de la deuxième partie 41b, 51b de la première portion 41, 51 dopée N est supérieure d'au moins 1% à celles de la première partie 41a, 51a. Par exemple, pour une largeur de la première partie 41a, 51a de la portion dopée N de 80$\mu$m, la largeur de la deuxième partie 41b, 51b peut être de 85$\mu$m.

Les diodes électroluminescentes 40 et diode Zener 50 peuvent présenter une épaisseur comprise entre 100nm et 50$\mu$m, l'épaisseur de la première portion 41, 51 dopée N peut être comprise entre 50nm et 20$\mu$m, celle de la zone active 43, 53 peut être comprise entre 10nm et 500nm, et celle de la seconde portion 42, 52 dopée P peut être comprise entre 50nm et 20$\mu$m. Les dimensions latérales des diodes, mesurées au niveau des surfaces 44, 54, peuvent être comprises entre 500nm et quelques millimètres, selon les applications visées. De préférence, les dimensions latérales des diodes électroluminescentes sont sensiblement identiques à celles de la diode Zener.

Les diodes électroluminescentes et diode Zener sont ici réalisées en un matériau comprenant majoritairement le composé GaN. Les zones actives peuvent comprendre au moins un puits quantique réalisé à base d'un composé semiconducteur présentant une énergie de bande interdite inférieure à celle des portions dopées. A titre d'exemple, les portions dopées sont réalisées en GaN et la zone active comporte une alternance de couches semiconductrices intrinsèques (non intentionnellement dopées) en GaN et d'au moins un puits quantique à base d'InGaN. A titre illustratif, les diodes électroluminescentes peuvent être adaptées à émettre une lumière bleue, c'est-à-dire dont le spectre d'émission présente un pic d'intensité compris entre 440nm et 490nm environ.

Les flancs latéraux des diodes sont revêtus d'une portion diélectrique 47, 57, à l'exception des surfaces de décrochement 46, 56. Plus précisément, les flancs latéraux ne comportant pas de décrochement sont recouverts de manière continue d'une portion diélectrique 47, 57. Les flancs latéraux comportant un décrochement sont revêtus d'une portion diélectrique en deux parties : une première partie 47a, 57a qui recouvre les flancs latéraux de la portion 42, 52 dopée P, de la zone active 43, 53 et de la première partie 41a, 51a de la portion 41, 51 dopée N ; et une seconde partie 47b, 57b, distincte de la première, qui recouvre les flancs latéraux de la seconde partie 41b, 51b de la portion 41, 51 dopée N. Ainsi, les surfaces de décrochement 46, 56 ne sont pas revêtues d'une portion diélectrique 47, 57. La portion diélectrique 47, 57 recouvre en outre les flancs latéraux de la portion conductrice 45, 55.

La puce optoélectronique comporte en outre des éléments 48, 58 de connexion électrique, dits latéraux, intercalés entre les diodes électroluminescentes 40 et diode Zener 50, adaptés à porter à un potentiel électrique respectivement la première portion 41, 51 dopée N. Dans cet exemple, les éléments de connexion latéraux 48 s'étendent entre une couche diélectrique 12 et une couche de raccord électrique 13. Chaque diode électroluminescente 40 comporte ainsi un élément de connexion latéral 48 qui s'étend entre la portion diélectrique 47a, 47b située au niveau du décrochement 46 d'une part, et la portion diélectrique 47 ou 57 de la diode en regard d'autre part. L'élément de connexion latéral 48 est donc électriquement isolé des zones actives 43, 53 et des secondes portions 42, 52 dopée P des diodes électroluminescentes 40 et de la diode Zener 50. Il est cependant en contact électrique avec la première portion 41 dopée N de la diode électroluminescente 40 correspondante au niveau de la surface de décrochement 46, de manière à pouvoir porter la première portion 41 dopée N à un potentiel électrique donné.

De manière similaire, chaque diode Zener 50 comporte un élément de connexion dit latéral 58 adapté à porter la première portion 51 dopée N à un potentiel électrique donné. Il s'étend entre la portion diélectrique 57a, 57b située au niveau du décrochement 56 d'une part, et la portion diélectrique 47 d'une diode électroluminescente 40 en regard. L'élément de connexion latéral 58 est donc électriquement isolé des zones actives 43, 53 et des secondes portions 42, 52 dopée P. Il est cependant en contact électrique avec la première portion 51 dopée N de la diode Zener au niveau de la surface de décrochement 56, de manière à pouvoir porter cette première portion 51 dopée N à un potentiel électrique donné.

Les éléments de connexion latéraux 48, 58 sont électriquement isolés des portions conductrices 45, 55 par les portions diélectriques 47, 57. L'épaisseur et le matériau des portions diélectriques 47, 57 sont choisis de manière à obtenir un courant de fuite acceptable entre la portion conductrice et les éléments de connexion latéraux. L'épaisseur peut être de l'ordre de quelques nanomètres, par exemple être comprise entre 3nm et 5nm en fonction du matériau diélectrique utilisé.

Dans cet exemple, le dispositif optoélectronique peut comporter une couche diélectrique 12 intercalée entre les diodes électroluminescentes 40 et diode Zener 50 d'une part et le capot 30 d'autre part. Elle est réalisée en un matériau diélectrique, par exemple en $Si_3N_4$, de manière à éviter tout court-circuit entre les diodes 40, 50 et les éléments de connexion latéraux 48, 58 correspondant, et peut améliorer l'extraction lumineuse. L'épaisseur de la couche diélectrique 12 est par exemple comprise entre 500nm et $50\mu m$, de préférence entre $1\mu m$ et $5\mu m$. Elle comporte une face avant et une face arrière opposée. Les diodes électroluminescentes 40 et la diode Zener 50 sont au contact de la face arrière de la couche diélectrique 12 au niveau des surfaces 44, 54 respectives. La face avant peut présenter des motifs en relief (non représentés) situés en regard des surfaces d'émission 44 de manière à améliorer l'extraction du rayonnement lumineux émis par les diodes électroluminescentes 40.

Le dispositif optoélectronique peut comporter en outre une couche de raccord électrique 13 intercalée entre les diodes 40, 50 et la puce de commande 20, facilitant la connexion électrique entre la puce optoélectronique et la puce de commande. La couche de raccord 13 comporte ainsi des éléments de connexion électrique 14 assurant la connexion entre les éléments de connexion latéraux 48, 58 avec des portions conductrices de la puce de commande. Les éléments de connexion 14 sont électriquement isolés les uns des autres par un matériau diélectrique 15. La couche de raccord 13 présente une épaisseur sensiblement constante, dont une face opposée aux diodes 40, 50 forme la face arrière 11b de la puce optoélectronique.

Les éléments de connexion électrique 14 assurent ici la connexion en série des diodes électroluminescentes 40 et la connexion en parallèle de celles-ci avec la diode Zener 50, et permettent l'application de potentiels électriques donnés. Pour cela :

- un élément $14_1$ est en contact électrique avec la portion conductrice 45 d'une première diode électroluminescente $40_1$ de manière à pouvoir appliquer un potentiel électrique positif, noté ici $V_+$, à l'anode 42 correspondante ;
- des éléments $14_2$ assurent la connexion en série des diodes électroluminescentes $40_1$, $40_2$, $40_3$, et relient ainsi la cathode 41 d'une diode 40 amont à l'anode 42 de la diode 40 aval. Pour cela, elles sont en contact électrique avec l'élément 48 de la diode 40 amont et avec la portion conductrice 45 de la diode 40 aval ;
- un élément $14_3$ est en contact électrique avec l'élément 48 de la dernière diode électroluminescente $40_3$ de manière à appliquer un potentiel électrique négatif, noté ici $V_-$, à la cathode 41 correspondante. De manière avantageuse, ce même élément $14_3$ est également en contact avec la portion conductrice 55 de la diode Zener 50 de manière à appliquer le même potentiel électrique à l'anode 52 de la diode Zener ;
- enfin, un élément $14_4$ est en contact électrique avec l'élément 58 de la diode Zener 50 de manière à pouvoir appliquer le même potentiel électrique $V_+$ à la cathode 51.

Le dispositif optoélectronique d'émission de lumière comporte en outre une puce de commande 20 assemblée à la puce optoélectronique 10 au niveau de la face arrière 11b. La puce de commande assure la polarisation électrique des diodes 40, 50. Ainsi, les portions conductrices 22 assurent la polarisation en direct des diodes électroluminescentes 40 et la polarisation en indirect de la diode Zener 50. Plus précisément, un potentiel électrique positif $V_+$ est appliqué à l'anode 42 de la première diode électroluminescente $40_1$ par l'intermédiaire de l'élément de connexion $14_1$ et un potentiel électrique négatif $V_-$ est appliqué à la cathode 41 de la dernière diode électroluminescente $40_3$ par l'intermédiaire de l'élément de connexion $14_3$. De plus, le même potentiel négatif $V_-$ est appliqué à l'anode 52 de la diode Zener 50 par l'élément de connexion $14_3$ et le même potentiel positif $V_+$ est appliqué à la cathode 51 de la diode Zener 50 par l'élément de connexion $14_4$. Les diodes électroluminescentes connectées en série sont donc polarisées en direct et la diode Zener est polarisée en inverse.

La puce de commande peut également comporter les éléments électroniques, de type transistors, assurant la commande d'émission des diodes électroluminescentes. Alternativement, elle peut être un composant passif ne comportant essentiellement que des lignes de connexion électrique des portions conductrices jusqu'à des éléments électroniques déportés.

Le dispositif optoélectronique comprend également un capot 30 formé ici d'une plaque en un matériau transparent vis-à-vis de la gamme spectrale du rayonnement lumineux émis par les diodes électroluminescentes. La plaque transparente recouvre ici la face avant de la couche diélectrique.

Ainsi, on obtient un dispositif optoélectronique dont la pluralité de diodes électroluminescentes connectées en série est protégée contre les décharges électrostatiques par au moins une diode formant une diode Zener comportant majoritairement le même composé semiconducteur. On a donc un dispositif optoélectronique à protection intégrée dont le nombre de diodes Zener nécessaires pour assurer la protection ESD des diodes électroluminescentes est diminué par rapport à celui de l'exemple de l'art antérieur cité précédemment.

Par ailleurs, la structuration mesa coplanaire avec décrochement des diodes électroluminescentes et de la diode Zener permet d'obtenir une haute densité de diodes, avec des dimensions latérales des diodes pouvant être de l'ordre de $10\mu m$ à $50\mu m$. La connexion électrique des diodes est également facilitée, tout en garantissant une bonne isolation électrique entre les éléments de connexion électrique.

Enfin, le dispositif optoélectronique comporte des diodes électroluminescentes et au moins une diode Zener intégrées de manière monolithique, pouvant être obtenues de manière simultanée par un procédé de fabrication tel que détaillé plus loin.

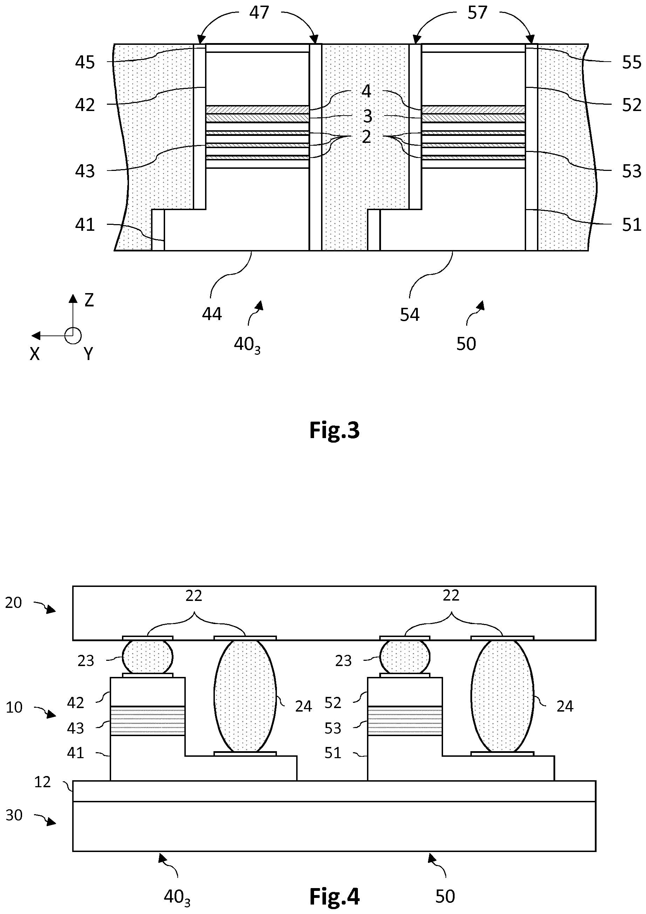

La figure 3 est une vue schématique détaillée en coupe d'une diode électroluminescente et d'une diode Zener d'un dispositif optoélectronique selon une variante du mode de réalisation décrit précédemment.

Dans cet exemple, la puce de commande 20 et le capot 30 (non représentés) sont identiques ou similaires à ceux décrits en référence à la figure 2. Les diodes électroluminescentes 40 et les diodes Zener 50 présentent une structure mesa coplanaire similaire à celle décrite en référence à la figure 2.

L'empilement de portions semiconductrices de la diode Zener est adapté pour être en mesure d'ajuster la valeur de la tension inverse de claquage. Pour cela, la diode Zener 50 comprend une première portion intermédiaire 3 dopée selon le type de conductivité de la première portion dopée 51, par exemple de type N, située entre la zone active 53 et la seconde portion dopée 52, et réalisée en un matériau comportant majoritairement le même composé semiconducteur que celui des diodes.

En ajustant le dopage de la première portion intermédiaire dopée 3, on est ainsi en mesure de modifier la valeur de la tension inverse de claquage, notamment en fonction du nombre N de diodes électroluminescentes que l'on souhaite connecter en série.

A titre d'exemple, pour une diode Zener réalisée à base de GaN comportant une première portion 51 dopée N et une seconde portion 52 dopée P, l'une et l'autre portions présentant un niveau de dopage de l'ordre de $10^{19}$ cm$^{-3}$, dont la zone active 53 comporte des puits quantiques multiples en InGaN intercalés entre des couches barrières de GaN intrinsèques (non intentionnellement dopées), la première portion intermédiaire 3 dopée N, ici réalisée en GaN, présente un niveau de dopage $N_d$ conduisant à une valeur Vc de tension de claquage indiquée dans le tableau ci-dessous :

| $N_d$ (donneurs/cm$^3$) de la portion 3 | Vc (V) de la diode Zener 50 |
|---|---|
| 5.10$^{18}$ donneurs/cm$^3$ | 30V |
| 1.10$^{19}$ donneurs/cm$^3$ | 20V |
| 5.10$^{19}$ donneurs/cm$^3$ | 18V |

On est alors en mesure de connecter en série un nombre N de diodes électroluminescentes en fonction de la valeur obtenue de la tension de claquage de la diode Zener.

De plus, lorsque la première portion intermédiaire 3 dopée N présente une épaisseur moyenne, mesurée suivant la direction Z, inférieure à 5nm environ, et de préférence comprise entre 1nm et 5nm, le niveau de dopage $N_d$ ne modifie sensiblement pas le comportement optoélectronique de la diode Zener 50 en direct. Ainsi, la valeur Vs de la tension directe de seuil reste sensiblement constante à une valeur ici de 3,2V et le rendement quantique interne maximal reste également sensiblement constant à une valeur ici de 70%. Ceci est d'autant plus avantageux lorsque, comme l'illustre la figure 3, la première portion intermédiaire 3 dopée N est également présente dans chacune des diodes électroluminescentes 40 connectées en série, les premières portions intermédiaires 3 étant alors coplanaires et réalisées en un matériau de même composition et de même niveau de dopage.

Par ailleurs, la diode Zener peut en outre comporter une seconde portion intermédiaire 4 dopée selon le même type de conductivité que celui de la seconde portion dopée 52, par exemple de type P. La seconde portion intermédiaire 4 dopée P est située entre la seconde portion 52 dopée P et la première portion intermédiaire 3 dopée N. En ajustant le niveau de dopage $N_a$ de la seconde portion intermédiaire 4 dopée P, on est également en mesure de modifier la valeur de la tension inverse de claquage.

A titre d'exemple, pour une diode Zener réalisée à base de GaN comportant une première portion 51 dopée N et une seconde portion 52 dopée P, l'une et l'autre portions présentant un niveau de dopage de l'ordre de $10^{19}$ cm$^{-3}$, dont la zone active 53 comporte des puits quantiques multiples en InGaN intercalés entre des couches barrières de GaN intrinsèques (non intentionnellement dopées), la première portion intermédiaire 3 étant réalisée en GaN dopée N avec un niveau de dopage $N_d$ de l'ordre de $10^{19}$ cm$^{-3}$, la seconde portion intermédiaire 4, ici réalisée en GaN, ayant un niveau de dopage $N_a$, on obtient une valeur Vc de tension de claquage de la diode Zener indiquée dans le tableau ci-dessous :

| $N_a$ (accepteurs/cm$^3$) de la portion 4 | Vc (V) de la diode Zener 50 |
|---|---|
| 1.10$^{18}$ accepteurs/cm$^3$ | 70V |
| 5.10$^{18}$ accepteurs/cm$^3$ | 30V |
| 1.10$^{19}$ accepteurs/cm$^3$ | 20V |

On est alors en mesure de connecter en série un nombre N de diodes électroluminescentes en fonction de la valeur obtenue de la tension de claquage de la diode Zener.

De plus, lorsque la seconde portion intermédiaire 4 dopée P présente une épaisseur moyenne, mesurée suivant la direction Z, inférieure à 50nm environ, et de préférence comprise entre 1nm et 50nm, le niveau de dopage $N_a$ ne modifie sensiblement pas le comportement optoélectronique de la diode Zener 50 en direct. Ainsi, la valeur Vs de la tension directe de seuil reste sensiblement constante à une valeur ici de 3,2V et le rendement quantique interne maximal reste également sensiblement constant à une valeur ici de 70%. Ceci est d'autant plus avantageux lorsque, comme l'illustre la figure 3, la seconde portion intermédiaire 4 dopée P est également présente dans chacune des diodes électroluminescentes 40 connectées en série, les secondes portions intermédiaires 4 étant alors coplanaires et réalisées en un matériau de même composition et de même niveau de dopage.

Le niveau de dopage des première et seconde portions intermédiaires dopées 3, 4 peut être homogène au sein des portions ou présenter un gradient de dopage. Dans ce cas, le niveau de dopage indiqué précédemment correspond au niveau de dopage moyen au sein de chacune des portions 3, 4.

L'empilement de portions semiconductrices de la diode Zener et des diodes électroluminescentes peut comporter une portion de blocage d'électrons située entre la zone active 43, 53 et la seconde portion dopée 42, 52, et de préférence entre les couches intermédiaires dopées 3, 4 et la seconde portion dopée 42, 52. La portion de blocage d'électrons peut être formée en un matériau comportant majoritairement le même composé semiconducteur des diodes 40, 50. Elle permet d'accroître le taux de recombinaisons radiatives au sein de la zone active. Dans le cas de diodes 40, 50 réalisées à base de GaN, la portion de blocage d'électrons peut être réalisée en AlGaN, de préférence avec une proportion atomique d'aluminium comprise entre 10% et 20% environ. De manière avantageuse, la première portion intermédiaire 3 et de préférence également la seconde portion intermédiaire 4 peuvent être réalisées en AlGaN, de manière à assurer en outre la fonction de blocage d'électrons.

Enfin, de manière alternative à l'utilisation des portions intermédiaires dopées 3, 4, la modification des niveaux de dopage de la seconde portion dopée 52 permet également d'ajuster la valeur de la tension de claquage, lorsque l'on dope à un niveau suffisant et de type N la zone active 53, par exemple de l'ordre de $5.10^{18}$ cm$^{-3}$. Cependant, lorsque les portions dopées 41, 42 et la zone active 43 des diodes électroluminescentes présentent un tel niveau de dopage, identique au niveau de dopage modifié des portions 51, 52, 53 de la diode Zener, le rendement quantique interne présente une valeur diminuée.

La figure 4 est une vue partielle en coupe schématique d'un dispositif optoélectronique selon un autre mode de réalisation, dans lequel la liaison électrique entre la puce de commande et la puce optoélectronique est réalisée par des billes 23, 24 électriquement conductrices et non pas au moyen de la couche de raccord électrique et des éléments de connexion électrique. L'espace délimité entre la puce optoélectronique et la puce de commande peut être rempli par un matériau diélectrique (non représenté) et de préférence thermiquement conducteur. Dans cet exemple, les flancs latéraux des diodes 40, 50 ne sont pas nécessairement recouvertes par des portions diélectriques 47, 57 illustrées sur les figures 2 et 3.

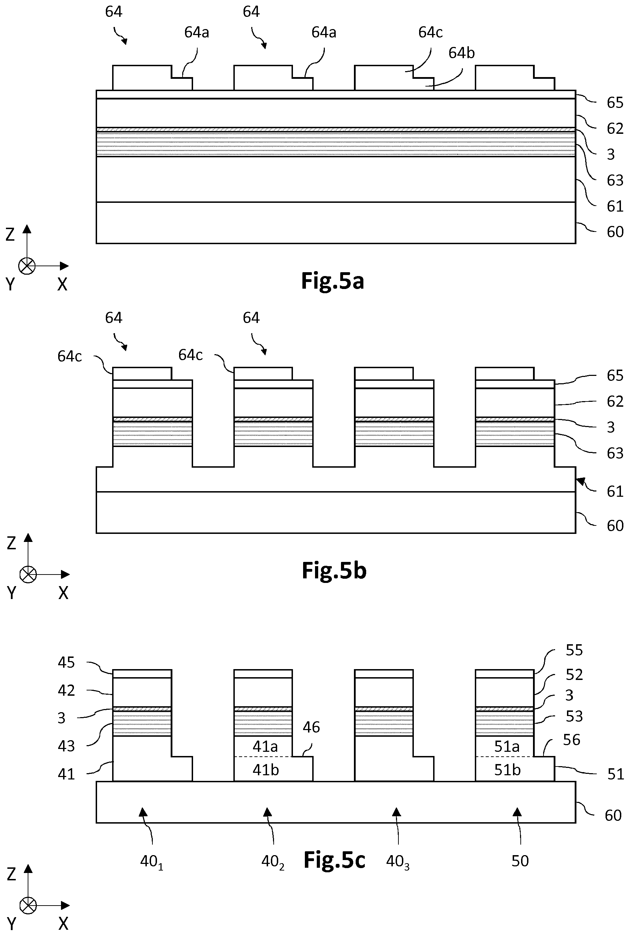

Les figures 5a à 5h illustrent des étapes d'un procédé de réalisation d'un dispositif optoélectronique tel que représenté sur la figure 2. Cet exemple est similaire à celui décrit dans la demande de brevet FR1456085 déposée le 27/06/2014 dont le texte est considéré comme faisant partie intégrante de la présente description.

En référence à la figure 5a, on réalise, sur un substrat de croissance 60, un empilement formé d'une couche semiconductrice 61 dopée selon un premier type de conductivité, par exemple de type N, d'une couche active 63 comportant au moins un puits quantique, d'une première couche intermédiaire 3 dopée N (et éventuellement une seconde couche intermédiaire 4 dopée P, non représentée), et d'une couche semiconductrice 62 dopée selon un second type de conductivité opposé au premier type, par exemple de type P. On revêt ensuite la surface libre de la couche 62 dopée P d'une couche 65 électriquement conductrice, par exemple en aluminium ou en argent. Ces couches empilées sont destinées à former les premières portions 41, 51 dopées N, les zones actives 43, 53, les premières portions intermédiaires 3 dopées N et les secondes portions 42, 52 dopées P des diodes électroluminescentes et de la diode Zener, ainsi que les portions conductrices 45, 55. A noter que la couche 61 dopée N peut comporter une première partie fortement dopée N+ recouvrant le substrat et une seconde partie recouvrant la première, et présentant un niveau de dopage inférieur. Les deux parties de la couche 61 dopée N peuvent être réalisées en un même matériau ou en deux matériaux différents comportant majoritairement le même composé semiconducteur. Par ailleurs, le substrat de croissance peut être en un matériau isolant, par exemple en saphir, ou en matériau semiconducteur, par exemple en silicium, ou à base d'un matériau III-V ou II-VI.

On dépose ensuite des plots structurés 64 de masque dur. Les plots 64 présentent une structure formant un décrochement 64a au niveau d'un flanc latéral. Ainsi, chaque plot 64 comporte une première partie 64b, formant une base qui repose sur la couche conductrice 65, dont les dimensions latérales définissent ultérieurement celles de la seconde partie 41b, 51b des portions 41, 51 dopées N des diodes 40, 50. Il comporte une seconde partie 64c, qui s'étend à partir de la première partie 64b, dont les dimensions latérales définissent ultérieurement celles de la première partie 41a, 51a des portions dopées N, de la zone active 43, 53 et de la portion 42, 52 dopée P des diodes. Les épaisseurs des deux parties des masques durs sont choisies en fonction de la vitesse de gravure des différents matériaux de l'empilement de couches.

En référence à la figure 5b, on réalise une gravure de l'empilement de la couche conductrice 65, de la couche 62 dopée P, de la couche intermédiaire 3 dopée N, de la couche active 63, et d'une partie de la couche 61 dopée N, à partir de la surface exposée de l'empilement entre les plots 64 de masque dur. La partie 64a formant décrochement des plots de masque dur est également gravée lors de cette étape. La gravure est une gravure sèche, telle qu'une gravure ionique réactive ou une gravure par plasma.

En référence à la figure 5c, on poursuit la gravure à partir de la surface exposée de l'empilement non recouverte par les plots 64 de masque dur. Ainsi, on obtient une pluralité de structures mesa coplanaires formées chacune d'un empilement d'une portion conductrice 45, 55, d'une portion 42, 52 dopée P, d'une portion intermédiaire 3 dopée N, d'une zone active 43, 53, et d'une portion 41, 51 dopée N présentant un décrochement 46, 56 entre une première partie 41a, 51a au contact de la zone active et une seconde partie 41b, 51b recouvrant le substrat 60. La première partie 41a, 51a de la portion dopée N présente des dimensions latérales dans le plan (X,Y) inférieures à celles de la seconde partie 41b, 51b de manière à former la surface de décrochement 46, 56. De préférence, les structures mesa destinées à former des diodes électroluminescentes présentent des dimensions latérales supérieures à celles des structures mesa adjacentes destinées à former des diodes Zener, de manière ainsi à maximiser la surface d'émission totale du dispositif optoélectronique 1. Les portions conductrices présentent une surface exposée, c'est-à-dire libre d'éventuels résidus de masque dur.

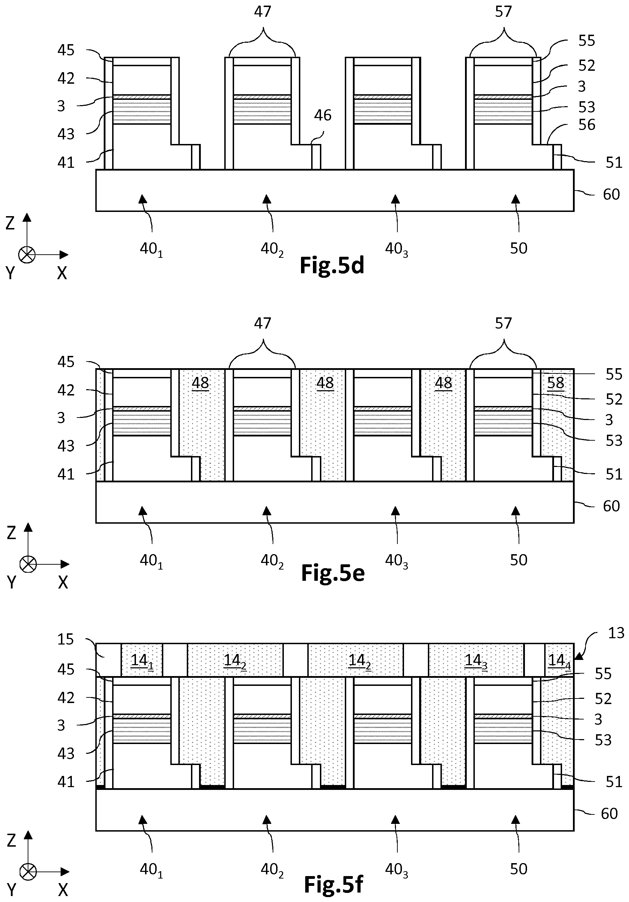

En référence à la figure 5d, on réalise les portions isolantes 47, 57 disposées dans les espaces entre les structures mesa et recouvrant les flancs latéraux des celles-ci, à l'exception des surfaces de décrochement 46, 56. Les portions isolantes peuvent être obtenues par un dépôt conforme d'une couche en un matériau diélectrique, par exemple de SiN d'une épaisseur comprise entre 3nm et 100nm, recouvrant continument les structures mesa et la surface exposée du substrat. On ne conserve ensuite que les portions situées sur les flancs latéraux des structures mesa en réalisant une gravure sèche des portions de la couche diélectrique située entre les structures mesa, sur les surfaces de décrochement et sur la face des portions conductrices.

De manière facultative, on peut réaliser, par des étapes classiques de lithographie, de gravure et de dépôt conforme, par exemple par la technique de pulvérisation cathodique ou de dépôt chimique en phase vapeur, un film (non représenté) en un matériau réfléchissant vis-à-vis de la longueur d'onde d'excitation, par exemple en aluminium ou en argent, recouvrant la surface exposée des portions isolantes 47 recouvrant les flancs latéraux des structures mesa destinées à former des diodes électroluminescentes 40, d'une épaisseur par exemple inférieure à 50nm pour de l'aluminium et inférieure à 75nm pour d'autres matériaux adéquats tels que l'argent. Une gravure sèche est éventuellement effectuée pour exposer à nouveau la surface des portions conductrices, et isoler électriquement les portions conductrices des films réfléchissants ou absorbants par les portions isolantes. Dans le cas où les films réfléchissants sont électriquement conducteurs, ils peuvent recouvrir les surfaces de décrochement correspondantes.

En référence à la figure 5e, on forme les éléments de connexion latéraux 48, 58 par remplissage de l'espace situé entre les structures mesa. Pour cela, on réalise un dépôt pleine plaque d'un matériau électriquement conducteur, suivi d'une planarisation mécano-chimique et/ou d'une gravure, par exemple une gravure RIE, de manière à supprimer le matériau conducteur déposé recouvrant les structures mesa et ainsi rendre libre la face supérieure des portions conductrices 45, 55 et celle des portions isolantes 47, 57. La face supérieure obtenue est alors sensiblement plane.

En référence à la figure 5f, on réalise une couche de raccord électrique 13 recouvrant la face supérieure de la structure obtenue à l'issue de l'étape précédente, la couche de raccord est formée d'un matériau diélectrique 15 entourant des éléments de connexion 14 (ici référencés $14_1$, $14_2$, $14_3$, $14_4$) qui s'étendent entre les deux faces opposées de la couche 13 et viennent au contact des portions conductrices 45, 55 et des éléments de connexion latéraux 48, 58. Pour cela, on dépose une couche diélectrique sur la structure obtenue, puis par lithographie et gravure, on définit des cavités destinées à recevoir les éléments de connexion. Ces cavités sont ensuite remplies par un dépôt pleine plaque d'un matériau électriquement conducteur, par exemple du cuivre ou de l'aluminium, suivi d'une planarisation mécano-chimique. La couche de raccord 13 présente une face libre sensiblement plane adaptée à un collage par exemple direct avec une puce de commande.

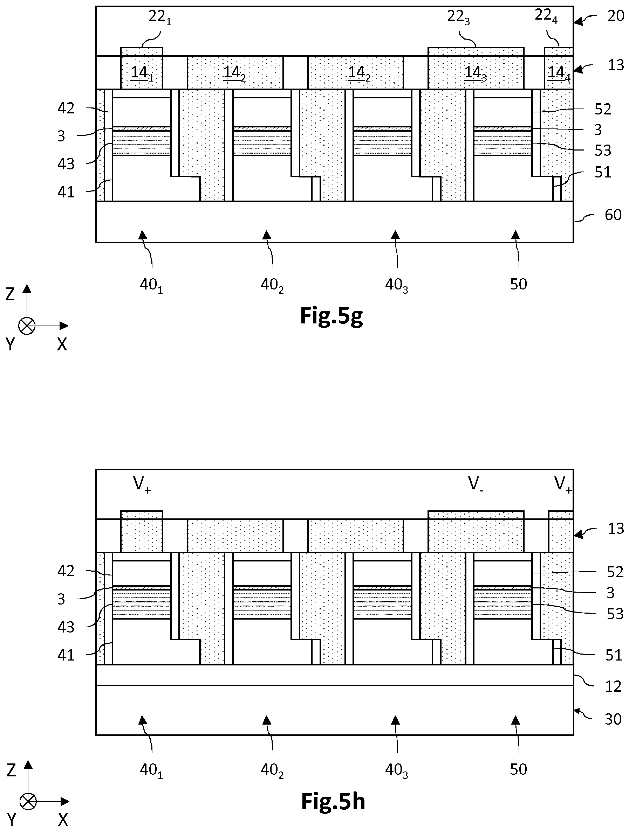

En référence à la figure 5g, on fixe la structure obtenue précédemment à une puce de commande 20 au niveau de la surface libre de la couche de raccord 13. La puce de commande comporte des portions électriquement conductrices 22 de polarisation (ici référencées $22_1$, $22_3$, $22_4$) venant au contact des éléments de connexion $14_1$, $14_3$, $14_4$ de la couche de raccord 13. La fixation peut notamment être assurée par un collage direct, ou collage par adhérence moléculaire, entre les surfaces métalliques respectives de la puce optoélectronique et de la puce de commande, ainsi qu'entre les surfaces diélectriques respectives des deux puces. Alternativement, une fixation par des microbilles de connexion électriques et/ou par thermocompression peut également être effectuée.

En référence à la figure 5h, on retire le substrat de croissance 60, par exemple par planarisation mécano-chimique et/ou une gravure sèche, de manière à exposer la face supérieure de la puce optoélectronique comportant les surfaces 44, 54 des diodes 40, 50.

On recouvre ensuite la face supérieure de la puce optoélectronique d'une couche 12 d'un matériau diélectrique que l'on planarise ensuite par exemple de manière mécano-chimique. La face libre de la couche 12 peut être localement structurée de manière à former des motifs en relief disposés en regard des surfaces d'émission 44 et éventuellement des surfaces 54. On fixe enfin un capot 30, formé d'une plaque réalisée en un matériau transparent, sur la face avant de la puce optoélectronique.

Le procédé de réalisation ici décrit permet ainsi d'obtenir un dispositif optoélectronique dans lequel les diodes électroluminescentes et la ou les diodes Zener sont intégrées de manière monolithique et obtenues de manière simultanée.

Des modes de réalisation particuliers viennent d'être décrits. Différentes variantes et modifications apparaîtront à l'homme du métier.

Ainsi, les modes de réalisation décrits précédemment mentionnent une première portion dopée N comportant une surface de décrochement et une portion dopée P située en regard de la puce de commande. Les types de conductivité des portions dopées peuvent bien entendu être inversés.

Le dispositif optoélectronique peut également comporter plusieurs ensembles de diodes électroluminescentes connectées en série, dont chaque ensemble est connectée par une diode Zener ou une paire de diodes Zener connectées en tête-bêche. Le nombre N de chaque ensemble de diodes électroluminescentes connectées en série est adapté en fonction de la valeur de la tension de claque de la diode Zener correspondante, cette valeur pouvant être ajustée par la ou les portions intermédiaires dopées 3, 4.

**Revendications**

1. Dispositif optoélectronique (1) comportant :

    - des diodes électroluminescentes (40) présentant chacune une tension directe dite de seuil (Vs) et une tension inverse de claquage (Vc), réalisées en un matériau comportant majoritairement un même composé semiconducteur, agencées de sorte que :
    - une pluralité de N diodes électroluminescentes (40), N≥2, sont connectées en série et aptes à être polarisées en direct ;
    - au moins une diode électroluminescente (50) est connectée en parallèle à la pluralité des N diodes électroluminescentes (40), et apte à être polarisée en inverse formant ainsi une diode Zener ;
    - le nombre N desdites diodes électroluminescentes (40) connectées en série étant adapté de sorte que la somme des N tensions de seuil (Vs) soit inférieure à la tension de claquage (Vc) de la diode Zener (50).

2. Dispositif optoélectronique (1) selon la revendication 1, dans lequel la diode Zener (50) comporte un empilement de portions semiconductrices dont une première portion (51) dopée selon un premier type de conductivité, une seconde portion (52) dopée selon un second type de conductivité opposé au premier type, ainsi qu'une première portion intermédiaire (3) dopée selon le premier type de conductivité, située entre lesdites première et seconde portions dopées (51, 52), présentant un niveau de dopage adapté de sorte que la tension de claquage (Vc) soit supérieure à la somme des N tensions de seuil (Vs).

3. Dispositif optoélectronique (1) selon la revendication 2, dans lequel les diodes électroluminescentes comportent un empilement de portions semiconductrices dont une première portion (41) dopée selon le premier type de conductivité, une seconde portion (42) dopée selon le second type de conductivité, ainsi qu'une première portion intermédiaire (3) dopée selon le premier type de conductivité, située entre lesdites première et seconde portions dopées (41, 42), lesdites portions semiconductrices des diodes électroluminescentes et de la diode Zener étant respectivement sensiblement coplanaires et réalisées en un matériau de même composition et de même niveau de dopage.

4. Dispositif optoélectronique (1) selon la revendication 3, dans lequel les premières portions intermédiaires dopées (3) des diodes électroluminescentes (40) et de la diode Zener (50) présentent une épaisseur inférieure ou égale à 5nm, et de préférence comprise entre 1nm et 5nm.

5. Dispositif optoélectronique (1) selon l'une quelconque des revendications 2 à 4, dans lequel la diode Zener comporte une seconde portion intermédiaire (4) dopée selon le second type de conductivité, située entre la première portion intermédiaire (3) dopée et la seconde portion dopée (52), présentant un niveau de dopage adapté de sorte que la tension de claquage (Vc) soit supérieure à la somme des N tensions de seuil (Vs).

6. Dispositif optoélectronique (1) selon la revendication 5, dans lequel les diodes électroluminescentes comporte une seconde portion intermédiaire (4) dopée selon le second type de conductivité, située entre la première portion intermédiaire dopée (3) et la seconde portion dopée (42), lesdites secondes portions intermédiaires dopées (4) des diodes électroluminescentes et de la diode Zener étant respectivement sensiblement coplanaires et réalisées en un matériau de même composition et de même niveau de dopage, et présentant une épaisseur inférieure ou égale à 50nm, et de préférence comprise entre 1nm et 50nm.

**7.** Dispositif optoélectronique (1) selon l'une quelconque des revendications précédentes, dans lequel ledit composé semiconducteur est choisi parmi un composé III-V, un composé II-VI, et un élément ou un composé IV.

**8.** Dispositif optoélectronique (1) selon l'une quelconque des revendications 1 à 7, dans lequel lesdites diodes électroluminescentes et la diode Zener présentent chacune un empilement de portions semiconductrices comprenant une première portion (41, 51) dopée selon un premier type de conductivité, une zone active (43, 53), et une seconde portion (42, 52) dopée selon un second type de conductivité opposé au premier type, lesdits empilements formant chacun une structure mesa sensiblement coplanaire.

**9.** Dispositif optoélectronique (1) selon la revendication 8, dans lequel la première portion dopée (41) des diodes électroluminescentes (40) et celle (51) de la diode Zener (50) présentent un flanc latéral comportant une surface de décrochement (46, 56) formée par une seconde partie (41b, 51b) de la première portion dopée (41, 51) vis-à-vis d'une première partie (41a, 51a) de celle-ci.

**10.** Dispositif optoélectronique (1) selon la revendication 9, dans lequel un élément de connexion électrique latéral (48, 58) s'étend au niveau d'une diode électroluminescente ou de la diode Zener de manière à être au contact électrique avec la surface de décrochement (46, 56) de la première portion dopée (41, 51) correspondante, l'élément de connexion latéral (48, 58) étant en outre électriquement isolé des secondes portions dopées (42, 52) et des portions actives (43, 53) de la diode (40, 50) considérée et de la diode électroluminescente ou de la diode Zener adjacente, par des portions diélectriques (47, 57) recouvrant des flancs latéraux des structures mesa.

**11.** Procédé de réalisation d'un dispositif optoélectronique (1) selon l'une quelconque des revendications précédentes, dans lequel :

i) on forme des diodes électroluminescentes (50) réalisées en un matériau comportant majoritairement un même composé semiconducteur,
ii) on connecte en série une pluralité de N diodes électroluminescentes (50), N≥2, celles-ci étant aptes à être polarisées en direct ;
iii) on connecte au moins une diode électroluminescente en parallèle à ladite pluralité de N diodes électroluminescentes, de manière à être polarisée en inverse formant ainsi une diode Zener, le nombre N desdites diodes électroluminescentes (40) connectées en série étant adapté de sorte que la somme des N tensions de seuil (Vs) soit inférieure à la tension de claquage (Vc) de la diode Zener.

**12.** Procédé selon la revendication 11, dans lequel l'étape i) comporte les sous-étapes dans lesquelles :

a. on réalise un empilement de couches comprenant une première couche semiconductrice dopée (61) et une seconde couche semiconductrice dopée (62) entre lesquelles est interposée une couche active (63) ;
b. on grave l'empilement de couches de manière à former une structure mesa destinée à former une pluralité de N diodes électroluminescentes (40) et une structure mesa destinée à former au moins une diode Zener (50), chaque structure mesa étant formée d'un empilement d'une première portion dopée (41, 51), d'une zone active (43, 53) et d'une seconde portion dopée (42, 52), la première portion dopée (41, 51) desdites structures mesa comportant un flanc latéral présentant une surface de décrochement (46, 56) ;
c. on réalise des portions diélectriques (47, 57) recouvrant les flancs latéraux des structures mesa à l'exception des surfaces de décrochement (46, 56) ;
d. on dépose un matériau électriquement conducteur (48, 58) entre les structures mesa, le matériau conducteur étant en contact de la surface de décrochement (46, 56) de la première portion dopée (41, 51) et électriquement isolé par des portions diélectriques (47, 57) de la zone active (43, 53) et de la seconde portion dopée (42, 52).

**13.** Procédé selon la revendication 12, dans lequel on réalise en outre, lors de l'étape a), une première couche intermédiaire (3) dopée selon le premier type de conductivité, située entre la couche active (63) et la seconde couche dopée (62), et de préférence une seconde couche intermédiaire (4) dopée selon le second type de conductivité, située entre la première couche intermédiaire (3) et la seconde couche dopée (62).

14. Procédé selon la revendication 13, dans lequel on ajuste le niveau de dopage de la première couche intermédiaire (3) et éventuellement de celui de la seconde couche intermédiaire dopée (4) de sorte que la tension de claquage (Vc) de la diode Zener soit inférieure à la somme des N tensions de seuil (Vs).

15. Procédé selon l'une quelconque des revendications 12 à 14, dans lequel on réalise des éléments de connexion électrique (14) adaptés à polariser en direct la pluralité des N diodes électroluminescentes (40) et en inverse la diode Zener (50) à partir de portions électriquement conductrices (22) de polarisation situées en regard des secondes portions dopées (42, 52).

**Patentansprüche**

1. Optoelektronische Vorrichtung (1), die aufweist:

   - Elektrolumineszenzdioden (40), die je eine so genannte Schwellen-Durchlassspannung (Vs) und eine Durchschlag-Sperrspannung (Vc) aufweisen, hergestellt aus einem Material, das mehrheitlich die gleiche Halbleiterverbindung aufweist, die so angeordnet sind, dass:
   - eine Vielzahl von N Elektrolumineszenzdioden (40), N≥2, in Reihe geschaltet sind und in Durchlassrichtung vorgespannt werden können;
   - mindestens eine Elektrolumineszenzdiode (50) mit der Vielzahl der N Elektrolumineszenzdioden (40) parallelgeschaltet ist und in Sperrrichtung vorgespannt sein kann, wodurch so eine Zener-Diode geformt wird;
   - die Anzahl N der in Reihe geschalteten Elektrolumineszenzdioden (40) so angepasst ist, dass die Summe der N Schwellenspannungen (Vs) niedriger als die Durchschlagspannung (Vc) der Zener-Diode (50) ist.

2. Optoelektronische Vorrichtung (1) nach Anspruch 1, wobei die Zener-Diode (50) eine Stapelung von Halbleiterabschnitten aufweist, von denen ein erster Abschnitt (51) gemäß einem ersten Leitfähigkeitstyp dotiert ist, ein zweiter Abschnitt (52) gemäß einem zweiten Leitfähigkeitstyp entgegengesetzt zum ersten dotiert ist, sowie ein gemäß dem ersten Leitfähigkeitstyp dotierter erster Zwischenabschnitt (3), der sich zwischen dem ersten und zweiten dotierten Abschnitt (51, 52) befindet, einen Dotiergrad aufweist, der so angepasst ist, dass die Durchschlagspannung (Vc) höher ist als die Summe der N Schwellenspannungen (Vs).

3. Optoelektronische Vorrichtung (1) nach Anspruch 2, wobei die Elektrolumineszenzdioden eine Stapelung von Halbleiterabschnitten aufweisen, von denen ein erster Abschnitt (41) gemäß dem ersten Leitfähigkeitstyp dotiert ist, ein zweiter Abschnitt (42) gemäß dem zweiten Leitfähigkeitstyp dotiert ist, sowie ein erster Zwischenabschnitt (3) gemäß dem ersten Leitfähigkeitstyp dotiert ist, der sich zwischen dem ersten und zweiten dotierten Abschnitt (41, 42) befindet, wobei die Halbleiterabschnitte der Elektrolumineszenzdioden und der Zener-Diode je im Wesentlichen koplanar und aus einem Material gleicher Zusammensetzung und gleichen Dotiergrads hergestellt sind.

4. Optoelektronische Vorrichtung (1) nach Anspruch 3, wobei die ersten dotierten Zwischenabschnitte (3) der Elektrolumineszenzdioden (40) und der Zener-Diode (50) eine Dicke geringer als oder gleich 5nm aufweisen, die vorzugsweise zwischen 1nm und 5nm liegt.

5. Optoelektronische Vorrichtung (1) nach einem der Ansprüche 2 bis 4, wobei die Zener-Diode einen zweiten Zwischenabschnitt (4) gemäß dem zweiten Leitfähigkeitstyp dotiert aufweist, der sich zwischen dem ersten dotierten Zwischenabschnitt (3) und dem zweiten dotierten Abschnitt (52) befindet, der einen Dotiergrad aufweist, der so angepasst ist, dass die Durchschlagspannung (Vc) größer als die Summe der N Schwellenspannungen (Vs) ist.

6. Optoelektronische Vorrichtung (1) nach Anspruch 5, wobei die Elektrolumineszenzdioden einen zweiten Zwischenabschnitt (4) gemäß dem zweiten Leitfähigkeitstyp dotiert aufweisen, der sich zwischen der ersten dotierten Zwischenabschnitt (3) und dem zweiten dotierten Abschnitt (42) befindet, wobei die zweiten dotierten Zwischenabschnitte (4) der Elektrolumineszenzdioden und der Zener-Diode je im Wesentlichen koplanar und aus einem Material gleicher Zusammensetzung und gleichen Dotiergrads hergestellt sind, und eine Dicke geringer als oder gleich 50nm aufweisen, die vorzugsweise zwischen 1nm und 50nm liegt.

7. Optoelektronische Vorrichtung (1) nach einem der vorhergehenden Ansprüche, wobei die Halbleiterverbindung unter einer Verbindung III-V, einer Verbindung II-VI, und einem Element oder einer Verbindung IV ausgewählt wird.

8. Optoelektronische Vorrichtung (1) nach einem der Ansprüche 1 bis 7, wobei die Elektrolumineszenzdioden und die Zener-Diode je eine Stapelung von Halbleiterabschnitten aufweisen, die einen ersten Abschnitt (41, 51) dotiert gemäß einem ersten Leitfähigkeitstyp, eine aktive Zone (43, 53) und einen zweiten Abschnitt (42, 52) enthalten, der gemäß einem zweiten Leitfähigkeitstyp entgegengesetzt zum ersten dotiert ist, wobei die Stapelungen je eine im Wesentlichen koplanare Mesa-Struktur bilden.

**9.** Optoelektronische Vorrichtung (1) nach Anspruch 8, wobei der erste dotierte Abschnitt (41) der Elektrolumineszenzdioden (40) et und derjenige (51) der Zener-Diode (50) eine Seitenflanke aufweisen, die eine Absatzfläche (46, 56) aufweist, die von einem zweiten Teil (41b, 51b) des ersten dotierten Abschnitts (41, 51) gegenüber einem ersten Teil (41a, 51a) von diesem geformt wird.

**10.** Optoelektronische Vorrichtung (1) nach Anspruch 9, wobei ein seitliches elektrisches Verbindungselement (48, 58) sich im Bereich einer Elektrolumineszenzdiode oder der Zener-Diode so erstreckt, dass es in elektrischem Kontakt mit der Absatzfläche (46, 56) des entsprechenden ersten dotierten Abschnitts (41, 51) ist, wobei das seitliche Verbindungselement (48, 58) außerdem von den zweiten dotierten Abschnitten (42, 52) und den aktiven Abschnitten (43, 53) der betrachteten Diode (40, 50) und der Elektrolumineszenzdiode oder der benachbarten Zener-Diode durch dielektrische Abschnitte (47, 57) elektrisch isoliert ist, die seitliche Flanken der Mesa-Strukturen bedecken.

**11.** Verfahren zur Herstellung einer optoelektronischen Vorrichtung (1) nach einem der vorhergehenden Ansprüche, wobei:

i) Elektrolumineszenzdioden (50) geformt werden, die aus einem Material hergestellt sind, das mehrheitlich eine gleiche Halbleiterverbindung aufweist,
ii) eine Vielzahl von N Elektrolumineszenzdioden (50), N≥2, in Reihe geschaltet werden, wobei diese in Durchlassrichtung vorgespannt werden können;
iii) mindestens eine Elektrolumineszenzdiode mit der Vielzahl von N Elektrolumineszenzdioden so parallelgeschaltet wird, das sie in Sperrrichtung vorgespannt wird, indem sie so eine Zener-Diode formt, wobei die Anzahl N der in Reihe geschalteten Elektrolumineszenzdioden (40) so angepasst wird, dass die Summe der N Schwellenspannungen (Vs) geringer als die Durchschlagspannung (Vc) der Zener-Diode ist.

**12.** Verfahren nach Anspruch 11, wobei der Schritt i) die Teilschritte aufweist, in denen:

a. eine Stapelung von Schichten hergestellt wird, die eine erste dotierte Halbleiterschicht (61) und eine zweite dotierte Halbleiterschicht (62) enthält, zwischen die eine aktive Schicht (63) eingefügt ist;
b. die Stapelung von Schichten so geätzt wird, dass eine Mesa-Struktur, die dazu bestimmt ist, eine Vielzahl von N Elektrolumineszenzdioden (40) zu formen, und eine Mesa-Struktur geformt werden, die dazu bestimmt ist, mindestens eine Zener-Diode (50) zu formen, wobei jede Mesa-Struktur von einer Stapelung eines ersten dotierten Abschnitts (41, 51), einer aktiven Zone (43, 53) und eines zweiten dotierten Abschnitts (42, 52) geformt wird, wobei der erste dotierten Abschnitt (41, 51) der Mesa-Strukturen eine Seitenflanke aufweist, die eine Absatzfläche (46, 56) aufweist;
c. dielektrische Abschnitte (47, 57) hergestellt werden, die die Seitenflanken der Mesa-Strukturen bedecken, mit Ausnahme der Absatzflächen (46, 56) ;
d. ein elektrisch leitendes Material (48, 58) zwischen den Mesa-Strukturen aufgebracht wird, wobei das leitende Material mit der Absatzfläche (46, 56) des ersten dotierten Abschnitts (41, 51) in Kontakt und durch dielektrische Abschnitte (47, 57) von der aktiven Zone (43, 53) und vom zweiten dotierten Abschnitt (42, 52) elektrisch isoliert ist.

**13.** Verfahren nach Anspruch 12, wobei außerdem im Schritt a) eine erste Zwischenschicht (3) dotiert gemäß dem ersten Leitfähigkeitstyp, die sich zwischen der aktiven Schicht (63) und der zweiten dotierten Schicht (62) befindet, und vorzugsweise eine zweite Zwischenschicht (4) dotiert gemäß dem zweiten Leitfähigkeitstyp hergestellt wird, die sich zwischen der ersten Zwischenschicht (3) und der zweiten dotierten Schicht (62) befindet

**14.** Verfahren nach Anspruch 13, wobei der Dotiergrad der ersten Zwischenschicht (3) und ggf derjenige der zweiten Zwischenschicht (4) so eingestellt werden, dass die Durchschlagspannung (Vc) der Zener-Diode geringer als die Summe der N Schwellenspannungen (Vs) ist.

**15.** Verfahren nach einem der Ansprüche 12 bis 14, wobei elektrische Verbindungselemente (14) hergestellt werden, die geeignet sind, die Vielzahl der N Elektrolumineszenzdioden (40) in Durchlassrichtung und die Zener-Diode (50) in Sperrrichtung vorzuspannen, ausgehend von elektrisch leitenden Vorspannungsabschnitten (22), die sich gegenüber den zweiten dotierten Abschnitten (42, 52) befinden.

**Claims**

1.  Optoelectronic device (1) comprising:

    - light-emitting diodes (40) each exhibiting a so-called threshold forward voltage (Vs) and a reverse breakdown voltage (Vc), produced in a material mostly comprising a same semiconductive compound, arranged such that:
    - a plurality of N light-emitting diodes (40), N≥2, are connected in series and capable of being forward-biased;
    - at least one light-emitting diode (50) is connected in parallel to the plurality of the N light-emitting diodes (40), and capable of being reverse-biased thus forming a Zener diode;
    - the number N of said light-emitting diodes (40) connected in series being adapted such that the sum of the N threshold voltages (Vs) is lower than the breakdown voltage (Vc) of the Zener diode (50).

2.  Optoelectronic device (1) according to Claim 1, in which the Zener diode (50) comprises a stack of semiconductive portions including a first portion (51) doped according to a first type of conductivity, a second portion (52) doped according to a second type of conductivity opposite to the first type, and a first intermediate portion (3) doped according to the first type of conductivity, situated between said first and second doped portions (51, 52), exhibiting a doping level adapted such that the breakdown voltage (Vc) is higher than the sum of the N threshold voltages (Vs).

3.  Optoelectronic device (1) according to Claim 2, in which the light-emitting diodes comprise a stack of semiconductive portions including a first portion (41) doped according to the first type of conductivity, a second portion (42) doped according to the second type of conductivity, and a first intermediate portion (3) doped according to the first type of conductivity, situated between said first and second doped portions (41, 42), said semiconductive portions of the light-emitting diodes and of the Zener diode being respectively substantially coplanar and produced in a material of the same composition and of the same doping level.

4.  Optoelectronic device (1) according to Claim 3, in which the first doped intermediate portions (3) of the light-emitting diodes (40) and of the Zener diode (50) have a thickness less than or equal to 5 nm, and preferably of between 1 nm and 5 nm.

5.  Optoelectronic device (1) according to any one of Claims 2 to 4, in which the Zener diode comprises a second intermediate portion (4) doped according to the second type of conductivity, situated between the first doped intermediate portion (3) and the second doped portion (52), exhibiting a doping level adapted such that the breakdown voltage (Vc) is higher than the sum of the N threshold voltages (Vs).

6.  Optoelectronic device (1) according to Claim 5, in which the light-emitting diodes comprise a second intermediate portion (4) doped according to the second type of conductivity, situated between the first doped intermediate portion (3) and the second doped portion (42), said second doped intermediate portions (4) of the light-emitting diodes and of the Zener diode being respectively substantially coplanar and produced in a material of the same composition and of the same doping level, and having a thickness less than or equal to 50 nm, and preferably of between 1 nm and 50 nm.

7.  Optoelectronic device (1) according to any one of the preceding claims, in which said semi-conductive compound is chosen from a III-V compound, a II-VI compound, and a IV element or compound.

8.  Optoelectronic device (1) according to any one of Claims 1 to 7, in which said light-emitting diodes and the Zener diode each have a stack of semiconductvie portions comprising a first portion (41, 51) doped according to a first type of conductivity, an active zone (43, 53), and a second portion (42, 52) doped according to a second type of conductivity opposite to the first type, said stacks each forming a substantially coplanar mesa structure.

9.  Optoelectronic device (1) according to Claim 8, in which the first doped portion (41) of the light-emitting diodes (40) and that (51) of the Zener diode (50) have a lateral flank comprising a setback surface (46, 56) formed by a second part (41b, 51b) of the first doped portion (41, 51) with respect to a first part (41a, 51a) thereof.

10. Optoelectronic device (1) according to Claim 9, in which a lateral electrical connection element (48, 58) extends at the level of a light-emitting diode or of the Zener diode so as to be in electrical contact with the setback surface (46, 56) of the corresponding first doped portion (41, 51), the lateral connection element (48, 58) being further electrically insulated from the second doped portions (42, 52) and from the active portions (43, 53) of the diode (40, 50) concerned and from the adjacent light-emitting diode or Zener diode, by dielectric portions (47, 57) covering the lateral flanks of the mesa structures.

11. Method for producing an optoelectronic device (1) according to any one of the preceding claims, in which:

   i) light-emitting diodes (50) are formed that are produced in a material mostly comprising a same semi-conductive compound,
   ii) a plurality of N light-emitting diodes (50), N≥2, the latter being capable of being forward-biased, are connected in series;
   iii) at least one light-emitting diode is connected in parallel to said plurality of N light-emitting diodes, so as to be reverse-biased thus forming a Zener diode, the number N of said light-emitting diodes (40) connected in series being adapted such that the sum of the N threshold voltages (Vs) is lower than the breakdown voltage (Vc) of the Zener diode.

12. Method according to Claim 11, in which the step i) comprises the substeps in which:

   a. a stack of layers is produced comprising a first doped semiconductive layer (61) and a second doped semiconductive layer (62) between which is inserted an active layer (63);
   b. the stack of layers is etched so as to form a mesa structure intended to form a plurality of N light-emitting diodes (40) and a mesa structure intended to form at least one Zener diode (50), each mesa structure being formed by a stack of a first doped portion (41, 51), an active zone (43, 53) and a second doped portion (42, 52), the first doped portion (41, 51) of said mesa structures comprising a lateral flank having a setback surface (46, 56);
   c. dielectric portions (47, 57) are produced covering the lateral flanks of the mesa structures except for the setback surfaces (46, 56);
   d. an electrically conductive material (48, 58) is deposited between the mesa structures, the conductive material being in contact with the setback surface (46, 56) of the first doped portion (41, 51) and electrically insulated by dielectric portions (47, 57) from the active zone (43, 53) and from the second doped portion (42, 52).

13. Method according to Claim 12, in which there is also produced, in the step a), a first intermediate layer (3) doped according to the first type of conductivity, situated between the active layer (63) and the second doped layer (62), and preferably a second intermediate layer (4) doped according to the second type of conductivity, situated between the first intermediate layer (3) and the second doped layer (62).

14. Method according to Claim 13, in which the doping level of the first intermediate layer (3), and possibly that of the second doped intermediate layer (4) is adjusted such that the breakdown voltage (Vc) of the Zener diode is lower than the sum of the N threshold voltages (Vs).

15. Method according to any one of Claims 12 to 14, in which electrical connection elements (14) are produced that are suitable for forward-biasing the plurality of the N light-emitting diodes (40) and reverse-biasing the Zener diode (50) from biasing electrically conductive portions (22) situated facing the second doped portions (42, 52).

## Fig.1

$V_+$

$40_1$

$40_2$

$40_N$

$50_1$

$50_1'$

$V_-$

**Fig.1**

## Fig.2

1

20

$V_+$  $22_1$

$22_3$  $V_-$  $22_4$  $V_+$

15

$\underline{14_1}$  $\underline{14_2}$  47  $\underline{14_2}$  $\underline{14_3}$  57  $\underline{14_4}$

11b

13

45

42

$\underline{48}$  47a  $\underline{48}$  55  58

52

43

51a  53

41a

46  56

10

41

51

41b

47b  51b

12

11a

44  51b  57a 57b

30

54

$40_1$  $40_2$  $40_3$  50

Z

Y  X

**Fig.2**

**Fig.3**

**Fig.4**

**Fig.5a**

**Fig.5b**

**Fig.5c**

**Fig.5d**

**Fig.5e**

**Fig.5f**

**Fig.5g**

**Fig.5h**

## RÉFÉRENCES CITÉES DANS LA DESCRIPTION

**Documents brevets cités dans la description**

- US 20110057569 A1
- US 2010019264 A1
- FR 1456085

**Littérature non-brevet citée dans la description**

- **CHANG et al.** Improved ESD Protection by Combining InGaN-GaN MQW LEDs With GaN Schottky Diodes. *IEEE Electron Device Letters,* 2003, vol. 24 (3), 129-131
- **FAN et al.** III-nitride micro-emetter arrays development and applications. *J. Phys. D: Appl. Phys.,* 2008, vol. 41, 094001